Europäisches Patentamt

European Patent Office

Office européen des brevets

(19)

(11) Veröffentlichungsnummer: **0 401 420**
**A1**

(12) # EUROPÄISCHE PATENTANMELDUNG

(21) Anmeldenummer: 89110898.7

(22) Anmeldetag: 15.06.89

(51) Int. Cl.5: **G01R 33/035, G12B 17/02**

(30) Priorität: 05.06.89 DE 3918330

(43) Veröffentlichungstag der Anmeldung:
**12.12.90 Patentblatt 90/50**

(84) Benannte Vertragsstaaten:
**BE DE FR GB IT NL**

(71) Anmelder: **Siemens Aktiengesellschaft**
**Wittelsbacherplatz 2**
**D-8000 München 2(DE)**

(72) Erfinder: **Seifert, Heinrich, Dr.**
**Lachnerstrasse 63**
**D-8520 Erlangen(DE)**

(54) **HF-Abschirmvorrichtung in einem Dewar-Gefäss für eine supraleitende Magnetometer-Einrichtung.**

(57) Die HF-Abschirmvorrichtung ist in einem Dewar-Gefäß (2) außerhalb dessen Innenraumes (5) als allseitig HF-dichte Umhüllung um die supraleitenden Teile (10) einer Meßeinrichtung ausgebildet, wobei auch eine HF-Abschirmung des Querschnittes des Dewar-Halses (6) vorgesehen ist. Ferner dient die HF-Abschirmvorrichtung (9) zugleich als thermischer Strahlungsschild, wobei ihre die supraleitenden Teile (10) umgebenden Flächen auf einem Zwischentemperaturniveau gehalten sind. Darüber hinaus sind zur Unterdrückung von Wirbelströmen die Flächen (9a, 9b) der HF-Abschirmvorrichtung (9) zumindest im Bereich der supraleitenden Teile (10) in einzelne elektrisch leitende, untereinander isolierte Leiterbahnen aufgeteilt.

FIG 1

EP 0 401 420 A1

## HF-Abschirmvorrichtung in einem Dewar-Gefäß für eine supraleitende Magnetometer-Einrichtung

Die Erfindung bezieht sich auf eine Hochfrequenz(HF)-Abschirm vorrichtung in einem Dewar-Gefäß, das einen Innenraum mit einem Zugang über einen Hals aufweist und in dessen Innenraum die von einem von außen über den Hals zugeführten Kühlmittel zu kühlenden supraleitenden Teile einer Einrichtung zur Messung schwacher, von mindestens einer zu detektierenden Feldquelle hervorgerufener Magnetfelder angeordnet sind, wobei der die supraleitenden Teile der Meßeinrichtung enthaltende Bereich des Innenraumes von der HF-Abschirmvorrichtung umgeben ist. Eine derartige HF-Abschirmvorrichtung geht z.B. aus der EP-A-0 143 532 hervor.

Zur Messung sehr schwacher Magnetfelder ist eine Verwendung von supraleitenden Quanten-Interferometern, sogenannten "SQUIDs" (Abkürzung von "Superconducting QUantum Interference Devices"), allgemein bekannt (vgl. z.B. "J.Phys.E.: Sci.Instrum.", Vol. 13, 1980, Seiten 801 bis 813 oder "IEEE Trans. Electron Dev.", Vol. ED-27, No. 10, Okt. 1980, Seiten 1896 bis 1908). Als bevorzugte Anwendungsgebiete für diese Interferometer werden die Ermittlung submikroskopischer Bewegungen von Gravitäts-Wellen oder auch auf dem Gebiet der medizinischen Diagnostik die Magnetokardiographie oder Magnetoenzephalographie angesehen (vgl. z.B. "Physics Today", März 1986, Seiten 36 bis 44). Die von magnetischen Herz- bzw. Gehirnwellen hervorgerufenen Magnetfelder haben nämlich Feldstärken in der Größenordnung von nur etwa 50 pT bzw. 0,1 pT (vgl.z.B. "Biomagnetism -Proceedings Third International Workshop on Biomagnetism, Berlin 1980", Berlin/New York 1981, Seiten 3 bis 31). Diese sehr schwachen Felder müssen zudem noch bei Anwesenheit von verhältnismäßig großen Störfeldern zu detektieren sein.

Zur Messung derartiger, insbesondere biomagnetischer Magnetfelder in der genannten Größenordnung sind Meßeinrichtungen bekannt, die ein- oder insbesondere auch mehrkanalig ausgeführt sein können (vgl. z.B. die EP-B-0 111 827). Diese Einrichtungen enthalten je nach Anzahl der vorgesehenen Kanäle SQUID-Magnetometer mit supraleitenden Gradiometern erster oder höherer Ordnung. Bei einer entsprechenden, aus der genannten Literaturstelle "Physics Today" zu entnehmenden Magnetometer-Einrichtung sind deren supraleitende Gradiometer zusammen mit den ihnen zugeordneten SQUIDs innerhalb eines Dewar-Gefässes angeordnet. Hierbei ist eine Kühlung der supraleitenden Einbauten, insbesondere der hochempfindlichen SQUIDs, unter Vermeidung von direkten und indirekten magnetischen Störungen erforderlich.

SQUID-Systeme sind nämlich extrem empfindlich gegenüber hochfrequenter, elektromagnetischer Strahlung, die z.B. von Rundfunksendern oder mobilen Funkgeräten ausgeht. Der Störeinfluß beruht dabei auf einem Verwaschen von Strukturen in den Gleichstromkennlinien der SQUIDs. Die Störung äußert sich insbesondere in einem verschlechterten Signal zu Rausch-Verhältnis, einem Fehlabgleich einer den SQUIDs zugeordneten Elektronik und einem der Störamplitude proportionalen und dem Nutzsignal überlagerten Ausgangssignal der Meßeinrichtung.

Eine Möglichkeit, den Einfluß hochfrequenter Störquellen zu vermindern, wird darin gesehen, daß man die gesamte Meßeinrichtung in einem hochfrequent abgeschirmten Raum betreibt (vgl. z.B. "Rev.Sci.Instrum.", Vol. 53, No. 12, Dez. 1982, Seiten 1815 bis 1845). Stattdessen ist es auch möglich, die supraleitenden Teile der Meßeinrichtung selbst außen mit einer HF-Abschirmvorrichtung zu versehen. Eine derartige Abschirmung ist auch bei dem aus der eingangs genannten EP-A-0 143 532 zu entnehmenden Dewar-Gefäß realisiert. Das bekannte Dewar-Gefäß enthält ein im wesentlichen hohlzylindrisches warmes Außengehäuse um ein kaltes, ebenfalls hohlzylindrisches Innengehäuse. Zur thermischen Isolation ist ein Vakuum zwischen Außen- und Innengehäuse vorgesehen. Über den Hals des Gefässes wird in den Innenraum des Innengehäuses ein Kältemittel eingeleitet, um die dort angeordneten supraleitenden Einbauten der Meßeinrichtung auf der erforderlichen Betriebstemperatur zu halten. Diese supraleitenden Einbauten sind durch einen HF-Schild nach außen hin abgeschirmt. Dieser Schild befindet sich an der Innenwand des Innengehäuses und wird somit im Bereich der supraleitenden Einbauten ebenfalls auf deren Betriebstemperatur gehalten. Es hat sich jedoch gezeigt, daß diese Abschirmmaßnahmen zum Teil nicht ausreichend sind. So führt z.B. eine praktisch vollständige Umhüllung eines SQUID-Systems mit einer geschlossenen Metallfläche zu thermisch bedingten Wirbelströmen, die magnetische Rauschquellen darstellen. Andererseits bliebe durch ein Offenlassen der Abschirmfläche im SQUID-Bereich gerade die empfindlichste Stelle der gesamten Meßeinrichtung unabgeschirmt.

Aufgabe der vorliegenden Erfindung ist es deshalb, die HF-Abschirmvorrichtung der eingangs genannten Art dahingehend auszugestalten, daß eine effektive HF-Abschirmung zumindest der supraleitenden Teile der Meßeinrichtung erreicht wird, ohne daß damit eine Erhöhung des Rauschens bzw. eine Verschlechterung des Signal/Rausch-Verhältnisses verbunden ist.

Diese Aufgabe wird erfindungsgemäß mit den im Kennzeichen des Hauptanspruchs angegebenen Maßnahmen gelöst.

Die mit diesen Maßnahmen verbundenen Vorteile sind insbesondere darin zu sehen, daß zum einen mit der allseitig dichten HF-Abschirmung zugleich eine gute thermische Abschirmung des Tieftemperaturbereiches und damit der supraleitenden Teile der Meßeinrichtung erreicht wird. Da zum anderen die HF-Abschirmung mit Maßnahmen zur Unterdrückung von thermisch angeregten Wirbelströmen ausgestattet ist, läßt sich das von ihr verursachte Rauschen entsprechend minimal halten.

Vorteilhafte Ausgestaltungen der HF-Abschirmvorrichtung nach der Erfindung gehen aus den Unteransprüchen hervor.

Zur weiteren Erläuterung der Erfindung wird nachfolgend auf die Zeichnung Bezug genommen. Figur 1 zeigt einen Schnitt durch ein Dewar-Gefäß mit einer erfindungsgemäßen HF-Abschirmvorrichtung. Aus den Figuren 2 und 3 geht jeweils ein Detail einer solchen HF-Abschirmvorrichtung hervor. In Figur 4 ist eine weitere Ausbildungsmöglichkeit einer HF-Abschirmvorrichtung dargestellt. In den Figuren übereinstimmende Teile sind dabei mit denselben Bezugszeichen versehen.

SQUID-Magnetometer, wie sie für ein- oder insbesondere mehrkanalige Meßeinrichtungen vorgesehen werden können, sind prinzipiell bekannt. Sie enthalten zur Detektion der von einer biomagnetischen Feldquelle, insbesondere vom Herz oder vom Gehirn eines Patienten ausgehenden magnetischen Signale (magnetische Flüsse oder Flußgradienten) mindestens ein supraleitendes Gradiometer. Die Gradiometerspulen können dabei vorteilhaft zu Arrays zusammengefaßt sein. Die detektierten Signale werden dann über supraleitende oder normalleitende Verbindungsleiter einer der Kanalzahl entsprechenden Anzahl von SQUIDs zugeführt. Diesen SQUIDs, die ebenfalls zu einem Array zusammengefaßt sein können, ist eine externe Elektronik nachgeschaltet. In den Figuren sind diese an sich bekannten Teile nicht näher ausgeführt.

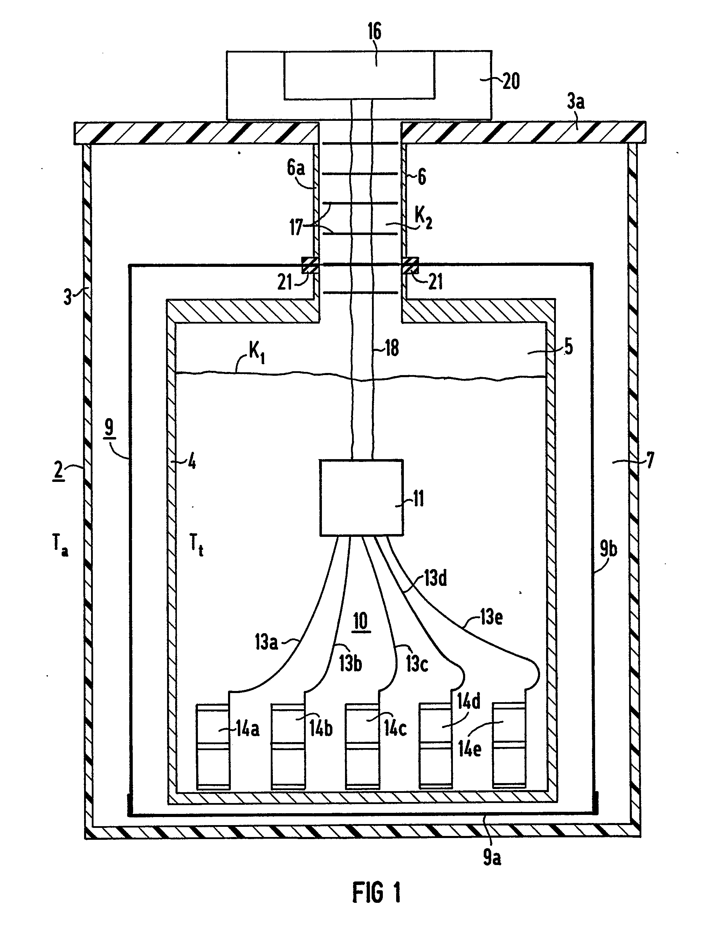

Gemäß dem in Figur 1 schematisch gezeigten Längsschnitt ist ein Dewar-Gefäß 2 mit zumindest weitgehend rotationssymmetrischem Aufbau vorgesehen, um die supraleitenden Teile einer solchen Meßeinrichtung (Magnetometers) aufzunehmen. Das Gefäß ist in bekannter Weise doppelwandig ausgeführt; d.h., es enthält eine auf einer Außentemperatur $T_a$ liegende Außenwand 3 und eine davon eingeschlossene Innenwand 4. Der von der Innenwand 4 begrenzte Innenraum 5 des Gefässes erlaubt einen Zugang über einen verhältnismäßig engen Hals 6. Der Zwischenraum 7 zwischen den Wänden 3 und 4 des Gefässes ist in bekannter Weise evakuiert und enthält gegebenenfalls eine in der Figur nicht dargestellte Superisolation. In diesem Zwischenraum, also außerhalb des Innenraumes 5, soll eine erfindungsgemäß ausgestaltete HF-Abschirmvorrichtung 9 angeordnet sein. Zur Erleichterung der Montage dieser Vorrichtung kann gegebenenfalls das kreisringförmige Oberteil 3a der Außenwand 3 bzw. des Gefässes 2 demontierbar sein. Die Abschirmvorrichtung umgibt vorteilhaft allseitig den Innenraum 5 quasi als ein HF-dichter Faraday'scher Käfig und ist zugleich als thermischer Strahlungsschild ausgebildet.

In dem Innenraum 5 des Dewar-Gefässes 2 ist die für eine Arbeitsperiode, beispielsweise einen Arbeitstag, erforderliche Menge eines flüssigen Kältemittels $K_1$, im allgemeinen flüssiges Helium, eingebracht und liegt somit auf einer entsprechenden Tieftemperatur $T_t$. Dieses Kältemittel soll zur Kühlung der allgemein mit 10 bezeichneten supraleitenden Teile der Meßeinrichtung unmittelbar oder mittelbar dienen. Die SQUIDs dieser Meßeinrichtung, die in der Figur nicht dargestellt und vorteilhaft zu einem Array zusammengefaßt sind, befinden sich dabei auf einem nur angedeuteten Chip 11. Sie sind über beispielsweise supraleitende Verbindungsleiter 12a bis 12e mit entsprechenden supraleitenden Gradiometern verbunden. Von diesen Gradiometern sind in der Figur nur fünf angedeutet und mit 14a bis 14e bezeichnet. Ihre Anzahl kann jedoch wesentlich darüber liegen. Nach außen hin sind die SQUIDs bzw. ihr Chip 11 mit einer externen Elektronik 16 über Anschlußleitungen verbunden. Diese Leitungen erstrecken sich dabei auch durch den Hals 6 hindurch, wo sie durch mehrere untereinander beabstandete, an sich bekannte Strahlungsschildplatten 17 (vgl. z.B. EP-A-0 200 958) hindurchführen. Diese Strahlungsschildplatten versperren jeweils großenteils den freien, d.h. von Einbauten freigelasseenen Querschnitt des Halses 6. Sie lassen jedoch einen hinreichenden Strömungsquerschnitt für nach außen entweichendes Abgas $K_2$ des in dem Innenraum 5 befindlichen flüssigen Kältemittels $K_1$ frei. Dieses Abgas $K_2$ ist im Halsbereich nicht nur zur Kühlung der Strahlungsschildplatten sondern auch der Anschlußleitungen zwischen dem SQUID-Chip 11 und der externen Elektronik 16 vorgesehen. Vorteilhaft können die Anschlußleitungen ebenso wie die Verbindungsleitungen 12a bis 12e in bekannter Weise als sogenannte Folienleiter ausgebildet sein (vgl z.B. die EP-A-0 185 186). In der Figur ist nur die Folie der Anschlußleitungen angedeutet und mit 18 bezeichnet. Ein Teil der mit dieser Anschlußleiterfolie verbundenen externen Elektronik 16 kann gegebenenfalls in ein Deckelteil 20 integriert sein, mit dem das Dewar-Gefäß 2 an der Öffnung seines Halses 6 abzudecken ist.

Nachgefüllt wird das flüssige Kältemittel K· von oben in den Innenraum 5 des Dewar-Gefässes 2 durch den Hals 6 beispielsweise über eine in der Figur nicht dargestellte, sich durch die Strahlungsschildplatten 17 hindurch erstreckende Rohrleitung, welche eine vakuumisolierte und im Gegenstrom mit dem Abgas $K_2$ des Kältemittels gekühlte Verbindung zu einem externen, nicht dargestellten Vorratsgefäß bildet. Die Nachfüllung kann dabei repetierend, z.B. im Tagesrhythmus erfolgen.

Gemäß der Erfindung soll die HF-Abschirmvorrichtung 9 auch als thermischer Strahlungsschild wirken. Hierzu muß sie aus einem thermisch gut leitenden Material wie z.B. aus Kupfer bestehen. Das Metall kann dabei auch auf einem elektrisch isolierenden Träger wie z.B. aus Kunststoff aufgebracht sein. Dieser Strahlungsschild umgibt unter Einschluß der im Bereich des Halses 6 befindlichen Strahlungsschildplatten 17 den gesamten Tieftemperaturbereich bzw. Innenraum 5. Er wird im allgemeinen aus mehreren Stücken zusammengesetzt. So ist z.B. gemäß dem dargestellten Ausführungsbeispiel angenommen, daß er ein etwa topfartiges Bodenteil 9a aufweist, das mit einem hohlzylindrischen Seitenteil 9b HF-leitend verbunden, beispielsweise verlötet oder verklebt ist. Gekühlt wird die Abschirmvorrichtung zweckmäßig mit dem Abgas $K_2$ des Kältemittels $K_1$ auf z.B. etwa 100 K. Hierzu kann sie thermisch z.B. an eine oder mehrere der Strahlungsschildplatten 17 angekoppelt sein. Gemäß dem in der Figur dargestellten Ausführungsbeispiel ist angenommen, daß über mindestens eine Durchführung 21 in der Halswand 6a eine galvanische (elektrische) und thermische Verbindung mit einer Strahlungsschildplatte 17 besteht.

Da mit diesem Strahlungsschild zugleich eine hinreichende HF-Abschirmwirkung gewährleistet sein soll, muß er zum einen durchgehend HF-leitend, d.h. hinreichend HF-dicht, ausgebildet sein. Dies geschieht gemäß der dargestellten Ausführungsform am Dewar-Hals 6, wo die thermische Ankopplung an das Abgas $K_2$ erfolgt, durch eine galvanische oder kapazitive Verbindung mit den Strahlungsschirmplatten 17, die innerhalb der Dewar-Öffnung die Abschirmung übernehmen. Es ergibt sich so eine praktisch vollständig geschlossene Abschirmhülle um die HF-empfindlichen supraleitenden Teile 10 der Meßeinrichtung. Zum anderen muß für eine wirksame HF-Abschirmung der Strahlungsschild so ausgelegt sein, daß insbesondere im Bereich der supraleitenden Teile 10 der Meßeinrichtung keine thermisch angeregten Wirbelströme in ihm fließen können. Hierzu muß seine Metallisierung unterbrochen ausgebildet sein. D.h. die Fläche der HF-Abschirm vorrichtung 9 muß zumindest in diesem Bereich in einzelne elektrisch leitende, untereinander elektrisch isolierte Leiterbahnen aufgelöst sein. An diesen Stellen, an denen eine galvanische Verbindung wegen der geforderten Vermeidung thermischer Wirbelströme nicht möglich ist, wird durch eine Überlappung oder durch kreuzweises Schichten metallischer Bahnen eine kapazitive und damit HF-wirksame Kopplung hergestellt.

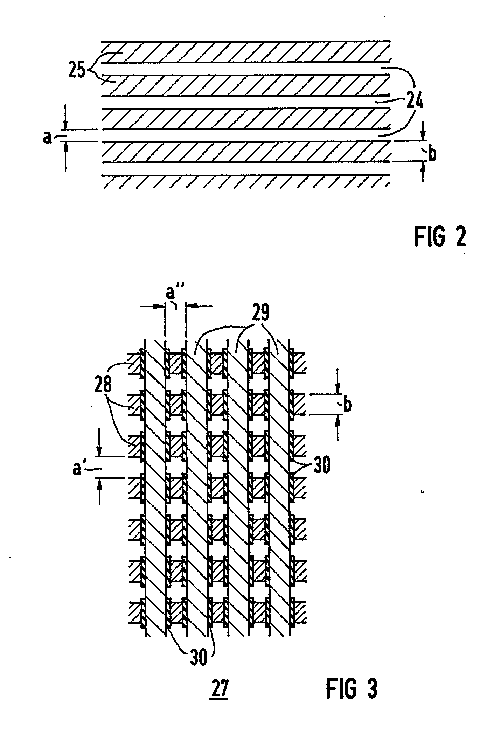

Zwei entsprechende Ausgestaltungen einer HF-Abschirmvorrichtung gehen aus den Figuren 2 und 3 hervor, welche jeweils schematisch einen Ausschnitt aus der Vorrichtung als Aufsicht zeigen.

Nach Figur 2 sind z.B. auf einem elektrisch isolierenden Träger 24, beispielsweise einer Kunststoffolie, als Leiterbahnen einzelne Streifenleiter 25 aus elektrisch und thermisch gut leitendem Material wie z.B. aus Cu aufgebracht, beispielsweise aufgeklebt. Die Streifenleiter 25 können auch aus einer mit Cu beschichteten Folie herausgearbeitet, beispielsweise herausgeätzt sein. Um die geforderte Wirbelstromunterdrückung zu gewährleisten, sollte die Breite b der Streifenleiter 25 im allgemeinen höchstens 2 mm betragen. Leiterbreiten b zwischen 0,5 mm und 1,5 mm haben sich als vorteilhaft erwiesen. Die Streifenleiter 25 erstrecken sich untereinander parallelliegend, wobei ihr gegenseitiger Abstand a zweckmäßig zwischen 1 und 2 mm gewählt wird. Im allgemeinen liegt a in der Größenordnung der Leiterbreiten b.

Statt der in Figur 2 dargestellten Streifenleiter 25 mit Bandform kann man ebensogut als Leiterbahnen auch drahtförmige Leiter mit z.B. kreisförmigem Querschnitt vorsehen, wobei dann der Kreisdurchmesser dieser Leiter in der Größenordnung der Leiterbreite b zu wählen ist.

Außerhalb des Bereichs der supraleitenden Teile 10 der Meßeinrichtung braucht die HF-Abschirmvorrichtung 9 nicht unbedingt in einzelne Leiterteile unterteilt zu sein. Sie kann dort gegebenenfalls auch durch eine geschlossene Fläche gebildet werden, da in diesem Teil der Abschirmvorrichtung eventuell angefachte Wirbelströme praktisch nicht mit den supraleitenden Teilen 10 der Meßeinrichtung, insbesondere mit den SQUIDs koppeln können. Die Streifenleiter 25 können deshalb an ihren Enden mit diesen Flächen elektrisch leitend verbunden, z.B. verlötet sein. Aber auch eine nur kapazitive Verbindung zwischen den Streifenleitern und der Fläche ist möglich.

Statt der Auflösung der Fläche der HF-Abschirmvorrichtung 9 in einzelne untereinander parallelliegende Streifenleiter 25 gemäß Figur 2 können auch netzartige Strukturen oder Gewebe oder Geflechte mit rechteckförmigen oder mit rautenförmigen oder auch ringförmigen Maschen zur Abschirmung des supraleitenden Teils 10 der Meßeinrichtung vorgesehen werden. In den Knoten bzw. Überlappungsbereichen dieser beispielsweise netzartigen Strukturen muß jedoch im allgemeinen eine gegenseitige elektrische Isolation der einzelnen Leiterteile gewährleistet sein.

Ein entsprechendes Ausführungsbeispiel einer derartigen HF-Abschirmvorrichtung ist in Figur 3 angedeutet. Ihre allgemein mit 27 bezeichnete Netzstruktur wird von Leiterstreifen 28 und 29 gebildet, wobei die untereinander parallel verlaufenden Leiterstreifen 28 die ebenfalls untereinander parallel verlaufenden Leiterstreifen 29 z.B. rechtwinklig kreuzen. In den Kreuzungsbereichen sind die Leiterstreifen 28 von den Leiterstreifen 29 z.B. durch einzelne dünne Isolationsflächenstücke 30 elektrisch getrennt. Gegebenenfalls können diese Isolationsflächenstücke auch eine geschlossene Isolationsschicht bilden, so daß dann die Leiterstreifen 28 und 29 in durch die Isolationsschicht getrennten Ebenen zu liegen kommen. Ferner ist es möglich, die Netzstruktur 27 auch aus Leiterstreifen oder Drähten aufzubauen, die z.B. mit einem Lack selbst isoliert ist. Aus Gründen der angestrebten Wirbelstromunterdrückung wird für die Netzstruktur eine Maschenweite gewählt, die in der Größenordnung des Abstandes a gemäß Figur 2 ist. D.h., die Abstände $a'$ und $a''$ zwischen den Streifenleitern 28 bzw. 29 liegen vorteilhaft zwischen 1 und 2 mm.

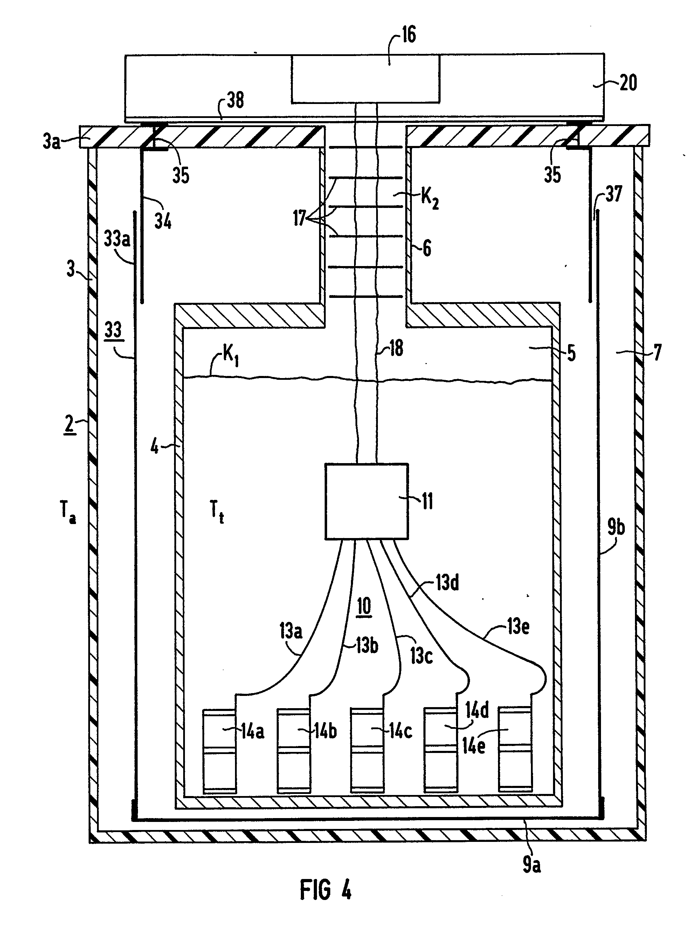

Bei dem in Figur 1 dargestellten Ausführungsbeispiel einer erfindungsgemäßen HF-Abschirmvorrichtung 9 wurde davon ausgegangen, daß diese Vorrichtung thermisch und elektrisch unmittelbar an eine der Strahlungsschildplatten 17 im Bereich des Halses 6 angekoppelt ist und so in etwa auf dem Temperaturniveau dieser Platte liegt. Hierzu sind die Durchführungen 21 durch die Halswand 6a erforderlich. Will man jedoch auf derartige Durchführungen verzichten, so ist eine geschlossene HF-Abschirmung auch über den Deckelteil 20 möglich. Ein entsprechendes Ausführungsbeispiel ist in dem Längsschnitt der Figur 4 schematisch dargestellt. Die allgemein mit 33 bezeichnete HF-Abschirmvorrichtung ist im Bereich der supraleitenden Teile 10 der Meßeinrichtung entsprechend der Vorrichtung 9 nach den Figuren 1 bis 3 ausgebildet. Statt der Verbindung zu einer der Strahlungsschirmplatten 17 im Halsbereich des Dewar-Gefäßes endet jedoch die Abschirmvorrichtung 33 im Halsbereich in einem hohlzylindrischen Endstück 33a. Dieses Endstück umschließt konzentrisch einen ebenfalls hohlzylindrischen Abschirmteil 34, der mit einer z.B. ringförmigen elektrischen Durchführung durch das demontierbare Oberteil 3a des Dewar-Gefässes 2 verbunden ist. Zwischen dem Endstück 33a und dem Abschirmteil 34 ist dabei ein schmaler Ringspalt 37 freigelassen, so daß zwischen diesen Teilen 33a und 34 nur eine kapazitive Kopplung besteht. Durch eine elektrisch leitende Fläche 38 an der Unterseite des Deckelteils 20 ist dann noch die Öffnung der Durchführung 35 und damit der Bereich des Halses 6 HF-dicht zu schließen. Bei dieser Ausführungsform der HF-Abschirmvorrichtung erfolgt deren Kühlung z.B. durch einen Strahlungsaustausch mit der Umgebung.

Ist eine derartige, bauartbedingte, nur schwache thermische Ankopplung nicht erwünscht, so ist selbstverständlich bei allen Ausführungsformen einer erfindungsgemäßen HF-Abschirmvorrichtung in einem Dewar-Gefässes auch eine direkte Kühlung mit Abgas z.B. über besondere Kühlleitungen an der HF-Vorrichtung möglich. Hierbei müssen auch die Maßnahmen zur Wirbelstromunterdrückung vorgesehen werden. Gegebenenfalls können sogar einzelne der diskreten Leiterbahnen der Vorrichtung als rohrförmige Kühlleitungen für das Abgas ausgebildet sein.

## Ansprüche

1. Hochfrequenz(HF)-Abschirmvorrichtung in einem Dewar-Gefäß, das einen Innenraum mit einem Zugang über einen Hals aufweist und in dessen Innenraum die von einem von außen über den Hals zugeführten Kühlmittel zu kühlenden supraleitenden Teile einer Einrichtung zur Messung schwacher, von mindestens einer zu detektierenden Feldquelle hervorgerufener Magnetfelder angeordnet sind, wobei der die supraleitenden Teile der Meßeinrichtung enthaltende Bereich des Innenraumes von der HF-Abschirmvorrichtung umgeben ist, **dadurch gekennzeichnet, daß**
- die HF-Abschirmvorrichtung (9, 33) außerhalb des Innenraumes (5) als allseitig HF-dichte Umhüllung um die supraleitenden Teile (10) der Meßeinrichtung ausgebildet ist, wobei auch eine HF-Abschirmung des Querschnittes des Halses (6) vorgesehen ist,
- die HF-Abschirmvorrichtung (9, 33) zugleich ein thermischer Strahlungsschild ist, wobei zumindest ihre die supraleitenden Teile (10) der Meßeinrichtung umgebenden Flächen auf einem Temperaturniveau zwischen der Temperatur ($T_t$) des flüssigen Kältemittels ($K_1$) und der Außentemperatur ($T_a$) des Gefässes (2) gehalten sind, und
- zur Unterdrückung von Wirbelströmen die Flächen (9a, 9b) der HF-Abschirmvorrichtung (9, 33) zumindest im Bereich der supraleitenden Teile (10) der Meßeinrichtung in einzelne elektrisch leitende, untereinander isolierte Leiterbahnen (25; 28, 29) aufgeteilt sind.

2. Abschirmvorrichtung nach Anspruch 1, **dadurch gekennzeichnet, daß** die Leiterbahnen (25, 28, 29) durch Drähte oder band- bzw. streifenförmige Leiter gebildet sind.

3. Abschirmvorrichtung nach Anspruch 1 oder 2, **dadurch gekennzeichnet, daß** die Leiterbahnen (28, 29) eine netzartige Struktur (27) oder ein Gewebe oder Geflecht bilden, wobei sie an den Überkreuzungspunkten gegenseitig isoliert sind (Fig. 3).

4. Abschirmvorrichtung nach einem der Ansprüche 1 bis 3, **dadurch gekennzeichnet,** daß die Leiterbahnen (25, 28, 29) eine Breite (b) von höchstens 2 mm, vorzugsweise zwischen 0,5 und 1,5 mm haben.

5. Abschirmvorrichtung nach einem der Ansprüche 1 bis 4, **dadurch gekennzeichnet,** daß untereinander parallelliegende Leiterbahnen (25, 28, 29) einen gegenseitigen Abstand (a, a', a'') von höchstens 2 mm haben.

6. Abschirmvorrichtung nach einem der Ansprüche 1 bis 5, **dadurch gekennzeichnet,** daß sie (9) mindestens eine von Abgas ($K_2$) des flüssigen Kältemittels ($K_1$) gekühlte Strahlungsschirmplatte (17) enthält, die in dem Hals (6) dessen freien Querschnitt großenteils versperrt.

7. Abschirmvorrichtung nach einem der Ansprüche 1 bis 5, **gekennzeichnet** durch ein den Hals (6) umgebendes Abschirmteil (34), welches HF-leitend
- an eine die Öffnung des Halses (6) HF-abdichtende, an einem Deckelteil (20) des Gefässes (2) angebrachte elektrisch leitende Fläche (38) sowie
- an die den Bereich der supraleitenden Teile (10) der Meßeinrichtung umgebenden Flächen (9a, 9b) der Abschirmvorrichtung (33)
angeschlossen ist (Fig. 4).

89 P 3275 E

FIG 1

89 P 3275  E

FIG 2

27          FIG 3

89 P 3275 E

FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | WO-A-8 807 835 (BIOMAGNETIC TECHNOLOGIES INC.) * Seite 5, Zeile 32 - Seite 6, Zeile 18; Seite 12, Zeile 16 - Seite 14, Zeile 24; Ansprüche 4,5; Figur 2 * | 1,2,4 | G 01 R 33/035 G 12 B 17/02 |
| A |    --- | 6,7 | |
| A | CRYOGENICS, Band 23, Nr. 6, Juni 1983, Seiten 299-302, Butterworth & Co. (Publishers) Ltd, Guildford, Surrey, GB; O.A. TESTARD et al.: "Cryostats for SQUID magnetometers" * Seite 300, Spalte 2, Zeilen 31-42 *    --- | 1,3 | |
| A | DE-A-3 430 406 (RIKEN EMC)    ----- | | |

RECHERCHIERTE SACHGEBIETE (Int. Cl.5)

G 01 R
G 12 B

Der vorliegende Recherchenbericht wurde für alle Patentansprüche erstellt

| Recherchenort | Abschlußdatum der Recherche | Prüfer |
|---|---|---|
| DEN HAAG | 23-04-1990 | HAASBROEK J.N. |

EPO FORM 1503 03.82 (P0403)

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

&: Mitglied der gleichen Patentfamilie, übereinstimmendes Dokument